# EUROPEAN PATENT APPLICATION

(11) **EP 4 177 940 A1**
(43) Date of publication of application: **10.05.2023**
(21) Application number: 21206134.5
(22) Date of filing: 03.11.2021
(51) Int. Cl.: H01L 23/31, H01L 23/00, H01L 21/56

(54) **A SEMICONDUCTOR PACKAGE ASSEMBLY AS WELL AS A METHOD FOR MANUFACTURING SUCH SEMICONDUCTOR PACKAGE ASSEMBLY**

(71) Applicant: Nexperia B.V., 6534 AB Nijmegen (NL)
(72) Inventor: Garete, April Joy, 6534AB Nijmegen (NL); Farrugia, Mark Luke, 6534AB Nijmegen (NL); Flauta, Randolph Estal, Nijmegen (NL)
(74) Representative: Pjanovic, Ilija

(57) **Abstract**

The present disclosure pertains to a semiconductor package assembly as well as a method for manufacturing such semiconductor package assembly. The semiconductor package assembly consists of a semiconductor package and a moulding resin case encapsulating the semiconductor package. The semiconductor package at least comprises a lead frame having a first frame side and a second frame side opposite to the first frame side; a silicon die structure having a first die side and a second die side opposite to the first side, the silicon die structure being mounted with its second die side on the first frame side of the lead frame; one or more bond wires electrically connecting the silicon die structure with the lead frame; as well as a coating layer covering the semiconductor package from the encapsulating moulding resin case, the coating layer being composed of two or more different amorphous layer coatings.

The use of a coating layer covering the complete semiconductor package including the bond wires and protecting it against the moulding resin subsequently encapsulating the complete semiconductor package, thus forming the encapsulating moulding resin case prevents any corrosion phenomenon from occurring as any halogen components contained in the moulding resin are no longer capable of affecting the bond wires and the intermetallic compound (IMC) at the wire-bond pad interface.

## Description

### TECHNICAL FIELD

The present disclosure relates to a semiconductor package assembly consisting of a semiconductor package and a moulding resin case encapsulating the semiconductor package, as well as a method for manufacturing such semiconductor package assembly.

### BACKGROUND OF THE INVENTION

When manufacturing a semiconductor package assembly, semiconductor components forming the semiconductor package are mounted to a lead frame and bond wires are placed electronically interconnecting the semiconductor die with the frame leads of the lead frame. For finalizing the semiconductor package assembly, the semiconductor package is encapsulated using a plastic resin, thus immobilizing and protecting the fragile bond wires and allowing a proper handling and processing of the semiconductor package assembly in semiconductor applications.

However, chronic corrosion problems occur in such wire bonded semiconductor package assemblies. The package assembly is more prone to corrosion when Cu, (Au) Pd-coated or Ag bond wires are used. The halogen components from the moulding compound attack the intermetallic compound (IMC) at the wire-die bond pad interface, which corrosion is further influenced under different temperature, moisture or high electrical bias conditions, due to chemical or moisture ingress from the assembly processes. Moreover, delamination in a semiconductor occurs when the adhesion of the plastic resin to the lead frame is not optimized.

Accordingly, it is a goal of the present disclosure to provide an improved semiconductor package assembly, of which the bond wires are not prone to corrosion.

### SUMMARY OF THE INVENTION

According to a first example of the disclosure, a semiconductor package assembly is proposed, which consists of a semiconductor package and a moulding resin case encapsulating the semiconductor package. The semiconductor package at least comprises a lead frame having a first frame side and a second frame side opposite to the first frame side; a silicon die structure having a first die side and a second die side opposite to the first side, the silicon die structure being mounted with its second die side on the first frame side of the lead frame; one or more bond wires electrically connecting the silicon die structure with the lead frame; as well as a coating layer covering the semiconductor package from the encapsulating moulding resin case, the coating layer being composed of two or more different amorphous layer coatings.

The use of a composite coating layer covering the semiconductor package including the bond wires and protecting it against the moulding resin subsequently encapsulating the complete semiconductor package, thus forming the encapsulating moulding resin case prevents any corrosion phenomenon from occurring as any halogen components contained in the moulding resin are no longer capable of affecting the bond wires and the intermetallic compound (IMC) at the wire-bond pad interface.

In a preferred example of the disclosure, the coating layer is composed of at least two amorphous layer coatings. Different layer characteristics or functionalities can be allocated to the different layer coatings used, thus improving the protection of the bond wires and extending its performance and lifespan. For example, a first layer coating can act as a corrosion barrier while a further layer coating may improve the adhesion of the mould resin - lead frame interface. This will protect the package from mechanical stress damage such as wire cracks or wire bond lift off during temperature cycling. The increased adhesion prevents the package from forming spaces in between different material interfaces that can serve as path for chemical attacks

In an example of a first layer coating coating the semiconductor package, said first layer coating may comprise an amorphous silicon (a-Si), organosilicon thin films, or amorphous hydrogenated SiC. Such first layer coating serves as a protective barrier against the corrosive halogens, thus forming the initial protections for e.g. the intermetallic compound (IMC).

The at least further layer coating coating the first layer coating may comprise an amorphous silicon oxide (a-SiOₓ) or aluminium(III)oxide (Al₂O₃). This second or further layer coating enhances the mechanical integrity of the first layer coating and provides a uniform and conformal coating throughout the exposed area. It may also serve as adhesion promoter with the moulding resin, when encapsulating the complete semiconductor package including the bond wires with moulding resin.

In a further beneficial example of the disclosure, the first layer coating is applied on the semiconductor package using a vapor depositing technique at a temperature lower than 200°C and preferably at a temperature range between 150°C - 200°C, whereas also the at least further layer coating can be applied on the first layer coating using a vapor depositing technique.

In a further example, the semiconductor package further comprises a lead frame tape mounted to the second frame side of the lead frame, in particular the lead frame consists of a central die pad and a plurality of frame leads, wherein the silicon die structure is mounted at the central die pad and the plurality of bond wires are electrically connected to the plurality of frame leads.

The disclosure also pertains to a method for manufacturing a semiconductor package assembly. In particular, the manufacturing method comprises the steps of
i) forming a semiconductor package by means of the sub-steps:
   i1) providing a lead frame having a first frame side and a second frame side opposite to the first frame side;
   i2) providing a silicon die structure having a first die side and a second die side opposite to the first side with its second die side on the first frame side of the lead frame;
   i3) wire bonding the silicon die structure with the lead frame with a plurality of wire bonds;
   and
ii) encapsulating the semiconductor package with a moulding resin;
   wherein, prior to step ii but after step i3, step i further comprises the sub-steps:
   i4) coating the semiconductor package with a layer coating consisting of an amorphous silicon (a-Si), an organosilicon thin film, or an amorphous hydrogenated SiC; and
   i5) coating the first layer coating with a further layer coating comprising an amorphous silicon oxide (a-SiOₓ) or aluminium(III)oxide (Al₂O₃).

By coating the complete semiconductor package including the bond wires by means of a coating layer composed of at least two sub-layers, protects the semiconductor package against the moulding resin, which is applied as a subsequent step for encapsulating the complete semiconductor package. Accordingly. the encapsulating moulding resin case thus formed prevents any corrosion phenomenon from occurring as any halogen components contained in the moulding resin are no longer capable of affecting the bond wires and in particular the intermetallic compound (IMC) at the wire-bond pad interface.

In a further improvement of the method according to the disclosure, sub-step i1 is preceded by the steps:
i0) providing a lead frame tape and mounting the lead frame with its second frame side on the lead frame tape.

Preferably, sub-step i4 comprises vapor depositing amorphous silicon at a temperature lower than 200°C and preferably at a temperature range between 150°C - 200°C, and more in particular the vapor depositing sub-step i4 is conducted under vacuum.

In an alternative example of the method according to the disclosure, the vapor depositing sub-step i4 is conducted under pressurized conditions ranging 50 mTorr - 5 Torr.

Preferably, in another example the vapor depositing sub-step i4 is a plasma enhanced CVD technique, in particular implementing a RF plasma source operating at 13.56MHz, and additionally the process depositing time of steps i4 and i5 amount to 10 minutes or less. In a further detailed process step, the gas flow of steps i4 and i5 amount 10-1000 standard cubic centimetres per minute (sccm).

### BRIEF DESCRIPTION OF THE DRAWINGS

The invention will now be discussed with reference to the drawings, which show in:
Figure 1 an example of a semiconductor package assembly according to the state of the art;
Figures 2-4 details of an example of a semiconductor package assembly according to the disclosure.

### DETAILED DESCRIPTION OF THE INVENTION

For a proper understanding of the invention, in the detailed description below corresponding elements or parts of the invention will be denoted with identical reference numerals in the drawings.

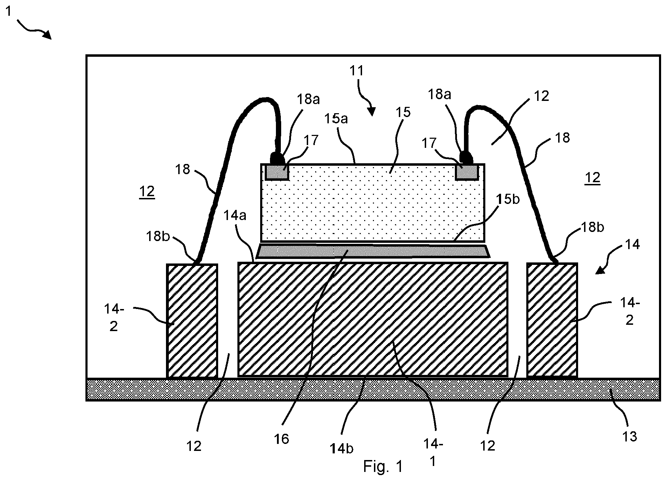

Figure 1 depicts a conventional lead frame-based IC package assembly 1 according to the prior art and prior to mold encapsulation. The main part is a semiconductor package, indicated with reference numeral 11. The semiconductor package 11 includes in a non-limited example, a lead frame 14 having a first frame side 14a and a second frame side 14b opposite to the first frame side 14a. In the Figures, the first frame side 14a can be classified as the upper or top side, whereas the second frame side 14b opposite to the first frame side 14a can be classified as the bottom or lower side.

Reference numeral 15 denoted a silicon die structure having a first (top or upper) die side 15a and a second (bottom or lower) die side 15b opposite to the first side 15a. The silicon die structure 15 is provided or mounted with its lower, second die side 15b on the upper, first frame side 14a of the lead frame 14. The mounting can be facilitated by means of a glue or soldering connection 16, which, during manufacturing, is provided between the lower, second die side 15b and the upper, first frame side 14a.

One or more bond wires 18 are electrically connecting the silicon die structure 15 with the lead frame 14. Accordingly, the silicon die structure 15 is provided with one or more bond pads 17, which in this example are provided on the upper, first die side 15a. In this example, the lead frame 14 may consist of a central die pad 14-1 configured to accommodate the mounting of the silicon die structure 15 with the assistance of the glue or soldering connection 16. The lead frame 14 also comprises a plurality of frame leads 14-2, which serve as contact pads for a bond wire 18.

Bond wires 18 are electrically connected with a first bond wire end (e.g. configured as a ball bond) 18a with a bond pad 17 using suitable known semiconductor connecting techniques. Furthermore, each bond wire 18 is electrically connected with its other second bond wire end 18b with a frame lead 14-2 of the lead frame 14.

Additionally, the semiconductor package 11 may further comprise a lead frame tape 13, which is mounted to the second, lower frame side 14b of the lead frame 14.

In the prior art, the semiconductor package 11 (comprised of the lead frame 13, the glue or soldering connection 16, the silicon die structure 15, the bond wires 18 and optionally the lead frame tape 13) is encapsulated in a plastic mould resin, which forms a encapsulating moulding resin case 12. The final component is a semiconductor package assembly 1, which consists of the semiconductor package 11 and the moulding resin case 12 encapsulating the semiconductor package 11.

In such known such wire bonded semiconductor package assemblies 1, chronic corrosion problems may occur. The prior art semiconductor package assembly 1 is more prone to corrosion when Cu, (Au) Pd-coated or Ag bond wires 18 are used. The halogen components from the moulding compound 12 attack the intermetallic compound (IMC) at the wire-bond pad interfaces 18a-17 and 18b-14-2, which corrosion is further influenced under different temperature, moisture or high electrical bias conditions, due to chemical or moisture ingress from the assembly processes.

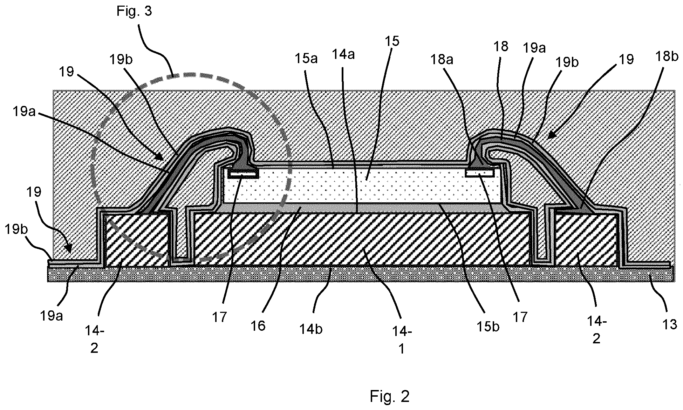

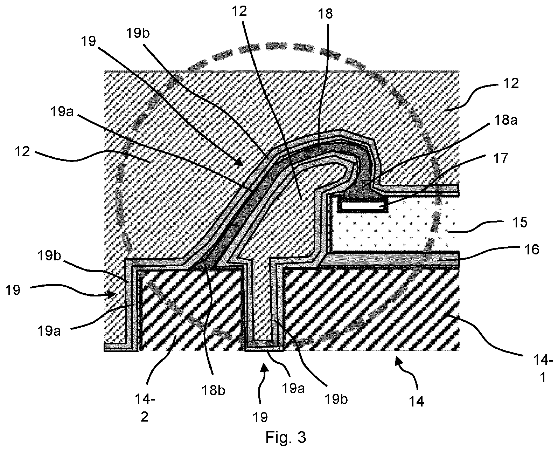

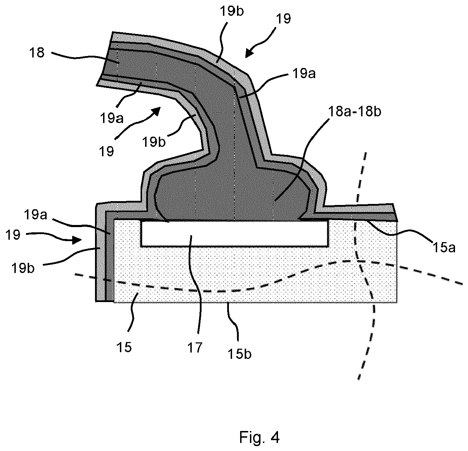

A beneficial example of the disclosure is disclosed in Figure 2 (with further detailed views in Figures 3 and 4), which example proposes a solution for the above corrosion problem.

Accordingly, a coating layer 19 is proposed, which covers and shields (protects) the semiconductor package 11 from the encapsulating moulding resin case 12. In a particular example, the coating layer 19 is composed of two or more different amorphous layer coatings, indicated with reference numerals 19a and 19b.

It is noted that the disclosure is not limited to two different amorphous layer coatings 19a-19b, it is also possible to have a coating layer 19 which is formed of more than two, for example three, four or even five, amorphous layer coatings 19a-19b-19b-19c-etc. etc.

The use of a coating layer 19 covering the complete semiconductor package 11 including the bond wires 18 and protecting it against aggressive components present in the moulding resin 12 subsequently encapsulating the complete semiconductor package 11 prevents any corrosion phenomenon from occurring. Any aggressive component, such as halogen components contained in the moulding resin 12 are no longer capable of affecting the bond wires 18 and the intermetallic compound (IMC) at the wire-bond pad interfaces 18a-17 and 18b-14-2.

In particular, different layer characteristics or functionalities can be allocated to the different layer coatings 19a-19b-etc., thus improving the protection of the bond wires 18 and extending its performance and lifespan. Typical layer characteristics or functionalities can be thickness, material density, material composition, etc. etc.

In an example of a first layer coating 19a directly coating the semiconductor package 11, said first layer coating 10a may comprise an amorphous silicon (a-Si), organosilicon thin films, or amorphous hydrogenated SiC. Such first layer coating 10a serves as a protective barrier against the corrosive halogens, thus forming the initial protections for e.g. the intermetallic compound (IMC) at the wire-bond pad interfaces 18a-17 and 18b-14-2.

The at least further layer coating 19b coating the first layer coating 19a may comprise an amorphous silicon oxide (a-SiOₓ) or aluminium(III)oxide (Al₂O₃).This second or further layer coating 19b enhances the mechanical integrity of the first layer coating 19a and provides a uniform and conformal coating throughout the exposed area. It may also serve as adhesion promoter with the moulding resin 12, when encapsulating the complete semiconductor package 11 including the bond wires 18 with moulding resin.

In a further beneficial example of the disclosure, the first layer coating 19a is applied on the semiconductor package 11 using a vapor depositing technique at a temperature lower than 200°C and preferably at a temperature range between 150°C - 200°C, whereas also the at least further layer coating 19b can be applied on the first layer coating 19a using a vapor depositing technique.

Accordingly, a method for manufacturing such semiconductor package assembly is part of the disclosure, which method in particular comprises the steps of
i) forming a semiconductor package 11 by means of the sub-steps:
   i1) providing a lead frame 14 having a first frame side 14a and a second frame side 14b opposite to the first frame side 14a;
   i2) providing a silicon die structure 15 having a first die side 15a and a second die side 15b opposite to the first side 15a with its second die side 15b on the first frame side 14a of the lead frame 14;
   i3) wire bonding the silicon die structure 15 with the lead frame 14 with a plurality of wire bonds 18;
   and
ii) encapsulating the semiconductor package 11 with a moulding resin 12;
   wherein, prior to step ii but after step i3, step i further comprises the sub-steps:
   i4) coating the semiconductor package 11 with a layer coating 19a consisting of an amorphous silicon (a-Si), an organosilicon thin film, or an amorphous hydrogenated SiC; and
   i5) coating the first layer coating 19a with at least a further layer coating 19b comprising an amorphous silicon oxide (a-SiOₓ) or aluminium(III)oxide (Al₂O₃).

The step of coating the complete semiconductor package 11 including the bond wires 18 by means of a coating layer 19 composed of at least two sub-layers 19a-19b, protects the semiconductor package 11 against the moulding resin 12, which is applied as a subsequent step for encapsulating the complete semiconductor package 11. Accordingly. the encapsulating moulding resin case 12 thus formed prevents any corrosion phenomenon from occurring as any halogen components contained in the moulding resin 12 are no longer capable of affecting the bond wires 18 and in particular the intermetallic compound (IMC) at the wire-bond pad interfaces 18a-17 and 18b-14-2.

In a further improvement of the method according to the disclosure, sub-step i1 is preceded by the steps:
i0) providing a lead frame tape 13 and mounting the lead frame 14 with its second frame side 14b on the lead frame tape 13.

Preferably, sub-step i4 comprises vapor depositing amorphous silicon at a temperature lower than 200°C and preferably at a temperature range between 150°C - 200°C, and more in particular the vapor depositing sub-step i4 is conducted under vacuum. In an alternative example of the method according to the disclosure, the vapor depositing sub-step i4 is conducted under pressurized conditions ranging 50 mTorr - 5 Torr. Preferably, in another example the vapor depositing sub-step i4 is a plasma enhanced CVD technique, in particular implementing a RF plasma source operating at 13.56MHz, and additionally the process depositing time of steps i4 and i5 amount to 10 minutes or less. In a further detailed process step, the gas flow of steps i4 and i5 amount 10-1000 standard cubic centimetres per minute (sccm).

The use of a stacked multi-layered coating layer 19 has several advantages over the prior art. As the stacked multi-layered coating layer 19 is applied after the manufacturing steps i2 of providing the silicon die structure 15 on the lead frame 14 and manufacturing step i3 of wire bonding the silicon die structure 15 with the lead frame 14 with a plurality of wire bonds 18, but prior to mould resin encapsulating, the coating of the complete semiconductor package 11 is not impacted or adversely affected.

The coating technique according to this disclosure is compatible to all existing lead frame-based packages, as the deposition of the multiple amorphous thin films 19a-19b-etc. can be deposited blanketly on large areas of lead frames 14 at low temperature (e.g. < 200 °C) and are readily scalable to mass production.

In particular, using a low temperature depositing technique, such as an atmospheric PECVD system, avoids excessive oxidation of the lead frame 14. The advantage of multi-layer deposition is its flexibility and the capability to cover large area surfaces, e.g. panel level processing during deposition. The surface of the lead frame 14 will be kept inert i.e. will not oxidize further, after depositing the first layer coating 19a.

For example, it has been found that the amorphous nature of the two or more coating layers 19a-19b-etc. is more resistant to mechanical fracture and delamination, as e.g. a crystalline thin film is susceptible fracture on stress induced during package singulation.

A further advantage is, that the coating technique can be implemented in-line using atmospheric PECVD systems and ultimately the finished semiconductor package assembly 10 resolves corrosion issues for released Cu wire products. Furthermore, the method provides a simple, non-chemical solution with the coating of the further layer coating 19b functioning as an adhesion promoter.

### LIST OF REFERENCE NUMERALS USED

- 1: semiconductor package assembly according to the prior art
- 10: semiconductor package assembly according to the disclosure
- 11: semiconductor package
- 12: moulding resin case
- 13: lead frame tape
- 14: lead frame
- 14a: first frame side of lead frame
- 14b: second frame side of lead frame
- 14-1: central die pad
- 14-2: frame leads
- 15: silicon die structure
- 15a: first die side of silicon die structure
- 15b: second die side of silicon die structure
- 16: glue or soldering connection
- 17: bond pad
- 18: bond wire
- 18a: first end of bond wire
- 18b: second end of bond wire
- 19: coating layer
- 19a: first amorphous layer coating
- 19b: further amorphous layer coating

## Claims

**1.** A semiconductor package assembly consisting of a semiconductor package and a moulding resin case encapsulating the semiconductor package, the semiconductor package at least comprising:
- a lead frame having a first frame side and a second frame side opposite to the first frame side;
- a silicon die structure having a first die side and a second die side opposite to the first side, the silicon die structure being mounted with its second die side on the first frame side of the lead frame;
- one or more bond wires electrically connecting the silicon die structure with the lead frame; as well as
- a coating layer covering the semiconductor package from the encapsulating moulding resin case, the coating layer being composed of two or more different amorphous layer coatings.

**2.** The semiconductor package assembly according to claim 1, wherein the coating layer is composed of two amorphous layer coatings.

**3.** The semiconductor package assembly according to claim 1 or 2, wherein a first layer coating coating the semiconductor package comprises an amorphous silicon (a-Si), organosilicon thin films, or amorphous hydrogenated SiC.

**4.** The semiconductor package assembly according to claim 1, 2, or 3, wherein at least a further layer coating coating the first layer coating comprises an amorphous silicon oxide (a-SiOₓ) or aluminium(III)oxide (Al₂O₃).

**5.** The semiconductor package assembly according to any one or more of the preceding claims, wherein the first layer coating is applied on the semiconductor package using a vapor depositing technique at a temperature lower than 200°C and preferably at a temperature range between 150°C - 200°C.

**6.** The semiconductor package assembly according to claim 5, wherein the at least further layer coating is applied on the first layer coating using a vapor depositing technique.

**7.** The semiconductor package assembly according to any one or more of the preceding claims, wherein the semiconductor package further comprises a lead frame tape mounted to the second frame side of the lead frame.

**8.** The semiconductor package assembly according to any one or more of the preceding claims, wherein the lead frame consists of a central die pad and a plurality of frame leads, wherein the silicon die structure is mounted at the central die pad and the plurality of bond wires are electrically connected to the plurality of frame leads.

**9.** A method for manufacturing a semiconductor package assembly comprising the steps of
i) forming a semiconductor package by means of the sub-steps:
i1) providing a lead frame having a first frame side and a second frame side opposite to the first frame side;
i2) providing a silicon die structure having a first die side and a second die side opposite to the first side with its second die side on the first frame side of the lead frame;
i3) wire bonding the silicon die structure with the lead frame with a plurality of wire bonds;
and
ii) encapsulating the semiconductor package with a moulding resin;
wherein, prior to step ii but after step i3, step i further comprises the sub-steps:
i4) coating the semiconductor package with a layer coating consisting of an amorphous silicon (a-Si), an organosilicon thin film, or an amorphous hydrogenated SiC; and
i5) coating the first layer coating with a further layer coating comprising an amorphous silicon oxide (a-SiOₓ) or aluminium(III)oxide (Al₂O₃).

**9.** The method for manufacturing a semiconductor package assembly according to claim 8, wherein sub-step i1 is preceded by the steps:
i0) providing a lead frame tape and mounting the lead frame with its second frame side on the lead frame tape.

**10.** The method for manufacturing a semiconductor package assembly according to claim 8 or 9, wherein sub-step i4 comprises vapor depositing amorphous silicon at a temperature lower than 200°C and preferably at a temperature range between 150°C - 200°C.

**11.** The method for manufacturing a semiconductor package assembly according to claim 10, wherein the vapor depositing sub-step i4 is conducted under vacuum.

**12.** The method for manufacturing a semiconductor package assembly according to claim 10, wherein the vapor depositing sub-step i4 is conducted under pressurized conditions ranging 50 mTorr - 5 Torr.

**13.** The method for manufacturing a semiconductor package assembly according to any one or more of the claims 10-12, wherein the vapor depositing sub-step i4 is a plasma enhanced CVD technique, in particular implementing a RF plasma source operating at 13.56MHz.

**14.** The method for manufacturing a semiconductor package assembly according to any one or more of the claims 10-13, wherein the process depositing time of steps i4 and i5 amount to 10 minutes or less.

**15.** The method for manufacturing a semiconductor package assembly according to any one or more of the claims 10-14, wherein the gas flow of steps i4 and i5 amount 10-1000 standard cubic centimetres per minute (sccm).
